(19) **Europäisches Patentamt / European Patent Office / Office européen des brevets**

(11) **EP 4 060 600 A1**

(12) **EUROPEAN PATENT APPLICATION**

(43) Date of publication:
21.09.2022 Bulletin 2022/38

(21) Application number: 21163831.7

(22) Date of filing: 19.03.2021

(51) International Patent Classification (IPC):
*G06T 5/00* (2006.01)    *G06T 5/10* (2006.01)
*G06T 5/50* (2006.01)    *H01J 37/22* (2006.01)
*H01J 37/28* (2006.01)

(52) Cooperative Patent Classification (CPC):
**G06T 5/10; G06T 5/003; G06T 5/50; H01J 37/222;
H01J 37/28;** G06T 2207/10061; G06T 2207/10144;
G06T 2207/20056; G06T 2207/20192;
G06T 2207/20221; G06T 2207/30148;
H01J 2237/223

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **HASAN, Shakeeb Bin
5500 AH Veldhoven (NL)**
• **GOOSEN, Maikel Robert
5500 AH Veldhoven (NL)**

(74) Representative: **ASML Netherlands B.V.
Corporate Intellectual Property
P.O. Box 324
5500 AH Veldhoven (NL)**

(54) **SEM IMAGE ENHANCEMENT**

(57) Disclosed herein is a method of reducing a sample charging effect in a scanning electron microscope (SEM) image, the method comprising: obtaining a first SEM image from a first electron beam scan with a parameter being a first quantity; obtaining a second SEM image from a second electron beam scan with the parameter being a second quantity different from the first quantity; and generating a reduced sample charging effect image based on convolution equations comprising a representation of the first SEM image, a representation of the second SEM image, a first point spread function corresponding to the first SEM image and a second point spread function corresponding to the second SEM image.

## Fig. 4

Obtaining a first SEM image — 402

Obtaining a second SEM image — 404

Generating an enhanced SEM image using convolution equations — 406

EP 4 060 600 A1

**Description**

TECHNICAL FIELD

The description herein relates to the field of image enhancement, and in particular to scanning electron microscopy (SEM) image enhancement.

BACKGROUND

In manufacturing processes of integrated circuits (ICs), unfinished or finished circuit components are inspected to ensure that they are manufactured according to design and are free of defects. Inspection systems utilizing optical microscopes or charged particle (e.g., electron) beam microscopes, such as a scanning electron microscope (SEM) can be employed. As the physical sizes of IC components continue to shrink, and their structures continue to become more complex, accuracy and throughput in defect detection and inspection become more important.

However, when inspecting electrically insulating materials, the qualities of the SEM images typically suffer from SEM-induced charging artifacts. A known technique that is used in SEM imaging to reduce SEM-induced charging artifacts is averaging of a plurality of SEM images obtained using different scan directions. However, further improvements in the art are desired.

SUMMARY

According to a first aspect of the invention, there is provided a method of reducing a sample charging effect in a scanning electron microscope (SEM) image, the method comprising: obtaining a first SEM image from a first electron beam scan with a parameter being a first quantity; obtaining a second SEM image from a second electron beam scan with the parameter being a second quantity different from the first quantity; and generating a reduced sample charging effect image based on convolution equations comprising a representation of the first SEM image, a representation of the second SEM image, a first point spread function corresponding to the first SEM image and a second point spread function corresponding to the second SEM image.

According to a second aspect of the invention, there is provided a method of reducing a sample charging effect in a scanning electron microscope (SEM) image, the method comprising: obtaining a first SEM image from an electron beam scan with a parameter being a first quantity; obtaining a second SEM image from an electron beam scan with the parameter being a second quantity different from the first quantity; and generating a reduced sample charging effect image based on a first and a second convolution equation; wherein the first convolution equation comprises: a representation of the first scanning electron microscope image; and a first charging point spread function corresponding to the first scanning electron microscope image; and the second convolution equation comprises: a representation of the second scanning electron microscope image; and a second charging point spread function corresponding to the second scanning electron microscope image.

According to a third aspect of the invention, there is provided a method of reducing a sample charging effect in a scanning electron microscope (SEM) image, the method comprising: obtaining a first SEM image from a first electron beam scan with a parameter being a first quantity; obtaining a second SEM image from a second electron beam scan with the parameter being a second quantity different from the first quantity; retrieving a point spread function from the first and second SEM images using convolution equations; generating a reduced sample charging effect image based on convolution equations comprising a representation of the first SEM image, a representation of the second SEM image, and the retrieved point spread function.

According to a fourth aspect of the invention, there is provided a method comprising: obtaining a first SEM image from a first electron beam scan with a parameter being a first quantity; obtaining a second SEM image from a second electron beam scan with the parameter being a second quantity different from the first quantity; and generating an image based on convolution equations comprising a representation of the first SEM image, a representation of the second SEM image, a first point spread function corresponding to the first SEM image and a second point spread function related to the first point spread function in dependence on a difference in sample charging effect between the first electron beam scan and the second electron beam scan.

BRIEF DESCRIPTIONS OF FIGURES

Other advantages of the embodiments of the present disclosure will become apparent from the following description taken in conjunction with the accompanying drawings wherein are set forth, by way of illustration and example, certain embodiments of the present invention.

Fig. 1 is a schematic diagram illustrating an exemplary electron beam inspection (EBI) system, consistent with embodiments of the present disclosure.

Fig. 2 is a schematic diagram illustrating an exemplary electron beam tool, consistent with embodiments of the present disclosure that may be a part of the exemplary electron beam inspection system of Fig. 1 .

Fig. 3 is an illustration of an example process of SEM-induced charging effect, consistent with embodiments of the present disclosure.

Fig. 4 is a flowchart of a method of generating a SEM image, consistent with embodiments of the present disclosure.

Fig. 5 is a flowchart of a method of generating a SEM image, consistent with embodiments of the present disclosure.

Fig. 6a is an illustration of an enhanced SEM image, consistent with embodiments of the present disclosure.

Fig. 6b is an illustration of a waveform associated with a first scan line associated with the SEM image, consistent with embodiments of the present disclosure.

Fig. 6c is an illustration of a waveform associated with a second scan line associated with the SEM image, consistent with embodiments of the present disclosure.

Fig. 7a is an illustration of a first point spread function, consistent with an embodiment of the present disclosure.

Fig. 7b is an illustration of a second point spread function, consistent with an embodiment of the present disclosure.

## DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations. Instead, they are merely examples of apparatuses and methods consistent with aspects related to the disclosed embodiments as recited in the appended claims. For example, although some embodiments are described in the context of utilizing electron beams, the disclosure is not so limited. Other types of charged particle beams may be similarly applied. Furthermore, other imaging systems may be used, such as optical imaging, photo detection, x-ray detection, etc.

Electronic devices are constructed of circuits formed on a piece of silicon called a substrate. Many circuits may be formed together on the same piece of silicon and are called integrated circuits or ICs. The size of these circuits has decreased dramatically so that many more of them can fit on the substrate. For example, an IC chip in a smart phone can be as small as a thumbnail and yet may include over 2 billion transistors, the size of each transistor being less than 1/1000th the size of a human hair. Making these extremely small ICs is a complex, time-consuming, and expensive process, often involving hundreds of individual steps. Errors in even one step have the potential to result in defects in the finished IC, thereby rendering it useless. Thus, one goal of the manufacturing process is to avoid such defects to maximize the number of functional ICs made in the process, that is, to improve the overall yield of the process.

One component of improving yield is monitoring the chip making process to ensure that it is producing a sufficient number of functional integrated circuits. One way to monitor the process is to inspect the chip circuit structures at various stages of their formation. Inspection can be carried out using a scanning electron microscope (SEM). A SEM can be used to image these extremely small structures, in effect, taking a "picture" of the structures. The image can be used to determine if the structure was formed properly and also if it was formed in the proper location. If the structure is defective, then the process can be adjusted so the defect is less likely to recur. It may be desirable to have higher throughput for defect detection and inspection processes to meet the requirements of IC manufacturers.

However, the errors of the structures indicated by a SEM image may be "real" or may be "false." For example, when the SEM images the structure, distortions may appear in the image, causing the structure to appear deformed or misplaced, when, in reality, there are no errors in the formation or placement of the structure. The distortions may be caused by charges accumulating and changing on the structures of wafer after interacting with the electrons introduced during the scanning phase. The SEM may thus no longer generate images that faithfully represent the structures.

The disclosure herein describes, among others, methods and systems for generating SEM images with reduced distortions. The SEM images generated according to methods disclosed herein, may thus be more faithful to the original structures, so that the ICs can be inspected with more accurate results, and no time is wasted on "false" errors. In one example, two (or more) images which are taken under different conditions, e.g. different scanning directions, are used. The two images and knowledge of the effect of the different conditions used to generate them can be used to mathematically calculate a more accurate image.

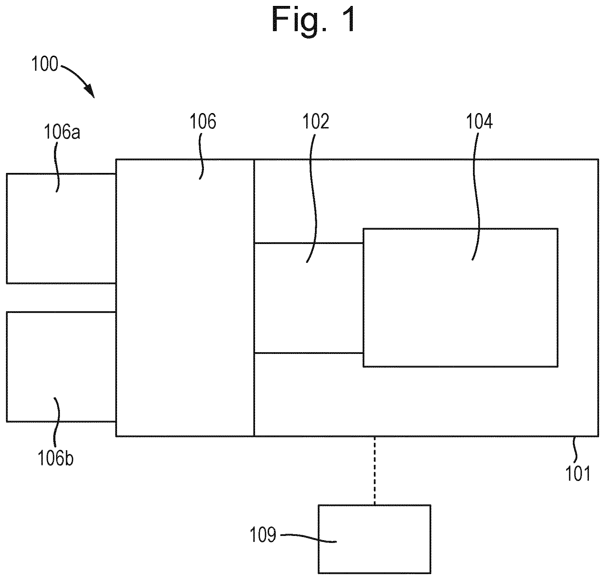

Reference is now made to Fig. 1, which illustrates an exemplary electron beam inspection (EBI) system 100 consistent with embodiments of the present disclosure. EBI system 100 may be used for imaging. As shown in Fig. 1, EBI system 100 may include a main chamber 101, a load/lock chamber 102, an electron beam tool 104, and an equipment front end module (EFEM) 106. Electron beam tool 104 is located within main chamber 101. While the description and drawings are directed to an electron beam, it is appreciated that the embodiments are not used to limit the present disclosure to specific charged particles.

EFEM 106 may include a first loading port 106a and a second loading port 106b. EFEM 106 may include additional loading port(s). First loading port 106a and second loading port 106b receive wafer front opening unified pods (FOUPs) that contain wafers (e.g., semiconductor wafers or wafers made of other material(s)) or samples to be inspected (wafers and samples may be used interchangeably).

One or more robotic arms (not shown) in EFEM 106 may transport the wafers to load/lock chamber 102. Load/lock chamber 102 is connected to a load/lock vacuum pump system (not shown) which removes gas molecules in load/lock chamber 102 to reach a first pressure below the atmospheric pressure. After reaching the first pressure, one or more robotic arms (not shown) may transport the wafer from load/lock chamber 102 to main chamber 101. Main chamber 101 is connected to a main chamber vacuum pump system (not shown) which removes gas molecules in main chamber 101 to reach a second pressure below the first pressure. After reaching the second pressure, the wafer is subject to inspection by electron beam tool 104. Electron beam tool 104 may be a single-beam system or a multi-beam system.

A controller 109 is electronically connected to electron beam tool 104 and may be electronically connected to other components as well. Controller 109 may be a computer configured to execute various controls of EBI system 100. Controller 109 may also include processing circuitry configured to execute various signal and image processing functions. While controller 109 is shown in Fig. 1 as being outside of the structure that includes main chamber 101, load/lock chamber 102, and EFEM 106, it is appreciated that controller 109 may be a part of the structure.

In some embodiments, controller 109 may include one or more processors (not shown). A processor may be a generic or specific electronic device capable of manipulating or processing information. For example, the processor may include any combination of any number of a central processing unit (or "CPU"), a graphics processing unit (or "GPU"), an optical processor, a programmable logic controllers, a microcontroller, a microprocessor, a digital signal processor, an intellectual property (IP) core, a Programmable Logic Array (PLA), a Programmable Array Logic (PAL), a Generic Array Logic (GAL), a Complex Programmable Logic Device (CPLD), a Field-Programmable Gate Array (FPGA), a System On Chip (SoC), an Application-Specific Integrated Circuit (ASIC), and any type circuit capable of data processing. The processor may also be a virtual processor that includes one or more processors distributed across multiple machines or devices coupled via a network.

In some embodiments, controller 109 may further include one or more memories (not shown). A memory may be a generic or specific electronic device capable of storing codes and data accessible by the processor (e.g., via a bus). For example, the memory may include any combination of any number of a random-access memory (RAM), a read-only memory (ROM), an optical disc, a magnetic disk, a hard drive, a solid-state drive, a flash drive, a security digital (SD) card, a memory stick, a compact flash (CF) card, or any type of storage device. The codes may include an operating system (OS) and one or more application programs (or "apps") for specific tasks. The memory may also be a virtual memory that includes one or more memories distributed across multiple machines or devices coupled via a network.

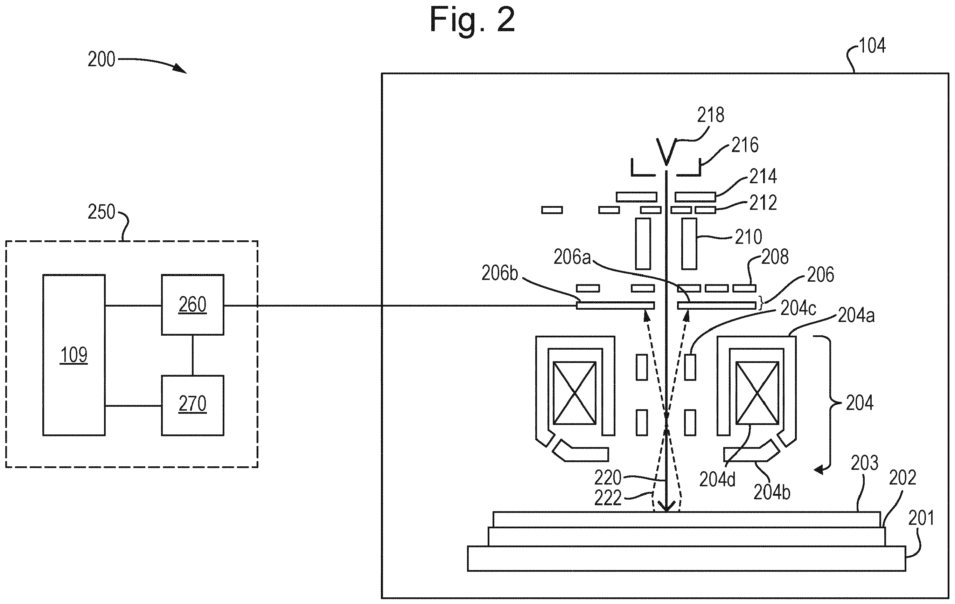

Reference is now made to Fig. 2, which illustrates an exemplary imaging system 200 according to embodiments of the present disclosure. Electron beam tool 104 of Fig. 2 may be configured for use in EBI system 100. Electron beam tool 104 may be a single beam apparatus or a multi-beam apparatus. As shown in Fig. 2, electron beam tool 104 may include a motorized sample stage 201, and a wafer holder 202 supported by motorized sample stage 201 to hold a wafer 203 to be inspected. Electron beam tool 104 may further include an objective lens assembly 204, an electron detector 206 (which includes electron sensor surfaces 206a and 206b), an objective aperture 208, a condenser lens 210, a beam limit aperture 212, a gun aperture 214, an anode 216, and a cathode 218. Objective lens assembly 204, in some embodiments, may include a modified swing objective retarding immersion lens (SORIL), which includes a pole piece 204a, a control electrode 204b, a deflector 204c, and an exciting coil 204d.

A primary electron beam 220 is emitted from cathode 218 by applying an acceleration voltage between anode 216 and cathode 218. Primary electron beam 220 passes through gun aperture 214 and beam limit aperture 212, both of which may determine the size of electron beam entering condenser lens 210, which resides below beam limit aperture 212. Condenser lens 210 focuses primary electron beam 220 before the beam enters objective aperture 208 to set the size of the electron beam before entering objective lens assembly 204. Deflector 204c deflects primary electron beam 220 to facilitate beam scanning on the wafer. For example, in a scanning process, deflector 204c may be controlled to deflect primary electron beam 220 sequentially onto different locations of top surface of wafer 203 at different time points, to provide data for image reconstruction for different parts of wafer 203. Moreover, deflector 204c may also be controlled to deflect primary electron beam 220 onto different sides of wafer 203 at a particular location, at different time points, to provide data for stereo image reconstruction of the wafer structure at that location. Further, in some embodiments, anode 216 and cathode 218 may generate multiple primary electron beams 220, and electron beam tool 104 may include a plurality of deflectors 204c to project the multiple primary electron beams 220 to different parts/sides of the wafer at the same time, to provide data for image reconstruction for different parts of wafer 203.

Exciting coil 204d and pole piece 204a generate a magnetic field that begins at one end of pole piece 204a and terminates at the other end of pole piece 204a. A part of wafer 203 being scanned by primary electron beam 220 may be immersed in the magnetic field and may be electrically charged, which, in turn, creates an electric field. The electric field reduces the energy of impinging primary electron beam 220 near the surface of wafer 203 before it collides with wafer 203. Control electrode 204b, being electrically isolated from pole piece 204a, controls an electric field on wafer 203 to prevent micro-arching of wafer 203 and to ensure proper beam focus.

A secondary electron beam 222 may be emitted from the part of wafer 203 upon receiving primary electron beam 220. Secondary electron beam 222 may form a beam spot on sensor surfaces 206a and 206b of electron detector 206. Electron detector 206 may generate a signal (e.g., a voltage, a current, or the like.) that represents an intensity of the beam spot, and provide the signal to an image processing system 250. The intensity of secondary electron beam 222, and the resultant beam spot, may vary according to the external or internal structure of wafer 203. Moreover, as discussed above, primary electron beam 220 may be projected onto different locations of the top surface of the wafer or different sides of the wafer at a particular location, to generate secondary electron beams 222 (and the resultant beam spot) of different intensities. Therefore, by mapping the intensities of the beam spots with the locations of wafer 203, the processing system may reconstruct an image that reflects the internal or surface structures of wafer 203.

Imaging system 200 may be used for inspecting a wafer 203 on sample stage 201 and includes an electron beam tool 104, as discussed above. Imaging system 200 may also include an image processing system 250 that includes an image acquirer 260, storage 270, and controller 109. Image acquirer 260 may include one or more processors. For example, image acquirer 260 may include a computer, server, mainframe host, terminals, personal computer, any kind of mobile computing devices, and the like, or a combination thereof. Image acquirer 260 may connect with a detector 206 of electron beam tool 104 through a medium such as an electrical conductor, optical fiber cable, portable storage media, IR, Bluetooth, internet, wireless network, wireless radio, or a combination thereof. Image acquirer 260 may receive a signal from detector 206 and may construct an image. Image acquirer 260 may thus acquire images of wafer 203. Image acquirer 260 may also perform various post-processing functions, such as generating contours, superimposing indicators on an acquired image, and the like. Image acquirer 260 may perform adjustments of brightness and contrast, or the like of acquired images. Storage 270 may be a storage medium such as a hard disk, cloud storage, random access memory (RAM), other types of computer readable memory, and the like. Storage 270 may be coupled with image acquirer 260 and may be used for saving scanned raw image data as original images, and post-processed images. Image acquirer 260 and storage 270 may be connected to controller 109. In some embodiments, image acquirer 260, storage 270, and controller 109 may be integrated together as one control unit.

In some embodiments, image acquirer 260 may acquire one or more images of a sample based on an imaging signal received from detector 206. An imaging signal may correspond to a scanning operation for conducting charged particle imaging. An acquired image may be a single image including a plurality of imaging areas. The single image may be stored in storage 270. The single image may be an original image that may be divided into a plurality of regions. Each of the regions may include one imaging area containing a feature of wafer 203.

In some embodiments, the SEM image may be an individual SEM image generated by a single scan of primary electron beam 220 on wafer 203 along a single scan direction. In some embodiments, the SEM image may be a first average SEM image generated by averaging multiple SEM images, each generated by a single scan of primary electron beam 220 on wafer 203 along the same scan direction. Embodiments of the present disclosure are not limited to any specific SEM image generated by any specific method, and the disclosed methods and systems may enhance SEM images that include, but are not limited to, the examples herein.

A challenge in defect detection is artifacts introduced by the inspection tools (e.g., a SEM). The artifacts do not originate from actual defects of the final products. They may distort or deteriorate the quality of the image to be inspected, and cause difficulties or inaccuracies in defect detection. For example, when inspecting electrically insulating materials using a SEM, the qualities of the SEM images typically suffer from SEM-induced charging artifacts.

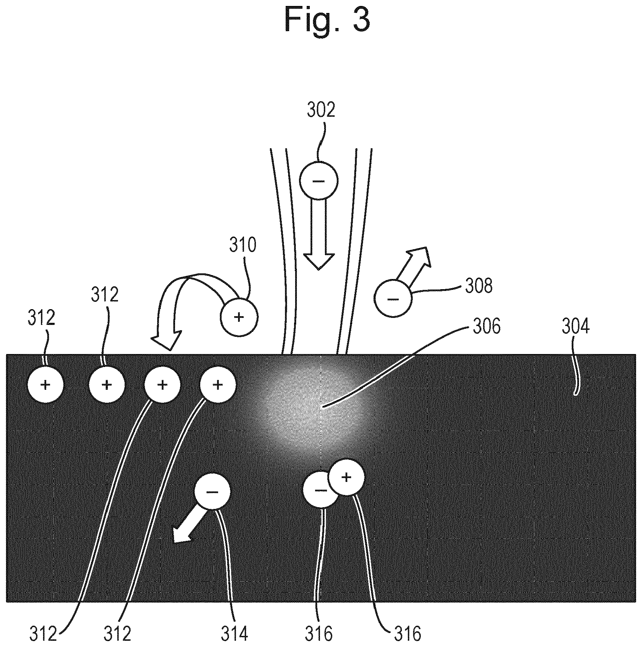

Reference is now made to Fig. 3, which is an illustration of an example process of SEM-induced charging effect, consistent with embodiments of the present disclosure. A SEM generates a primary electron beam (e.g., primary electron beam 220 in Fig. 2) for inspection. In Fig. 3, electrons of primary electron beam 302 are projected onto a surface of sample 304. Sample 304 may be of insulating materials, such as a non-conductive resist, a silicon dioxide layer, or the like. The electrons of primary electron beam 302 may penetrate the surface of insulator sample 304 for a certain depth, interacting with particles of insulator sample 304 in interaction volume 306. Some electrons of primary electron beam 302 may elastically interact with (e.g., in a form of elastic scattering or collision) the particles in interaction volume 306 and may be reflected or recoiled out of the surface of sample 304. An elastic interaction conserves the total kinetic energies of the bodies (e.g., electrons of primary electron beam 302 and particles of sample 304) of the interaction, in which no kinetic energy of the interacting bodies does not convert to other forms of energy (e.g., heat, electromagnetic energy, etc.). Such reflected electrons generated from elastic interaction may be referred to as backscattered electrons (BSEs), such as BSE 308 in Fig. 3. Some electrons of primary electron beam 302 may inelastically interact with (e.g., in a form of inelastic scattering or collision) the particles in interaction volume 306. An inelastic interaction does not conserve the total kinetic energies of the bodies of the interaction, in which some or all of the kinetic energy of the interacting bodies covert to other forms of energy. For example, through the inelastic interaction, the kinetic energy of some electrons of primary electron beam 302 may cause electron excitation and transition of atoms of the particles. Such inelastic interaction may also generate electrons exiting the surface of sample 304, which may be referred to as secondary electrons (SEs), such as SE 310 in Fig. 3. Yield or emission rates of BSEs and SEs depend on, e.g., the energy of the electrons of primary electron beam 302 and the material under inspection, among others. The energy of the electrons of primary electron beam 302 may be imparted in part by its acceleration voltage (e.g., the acceleration voltage between anode 216 and cathode 218 in Fig. 2). The quantity of BSEs and SEs may be more or fewer (or even the same) than the injected electrons of primary electron beam 302. An imbalance of incoming and outgoing electrons can cause accumulation of electric charge (e.g., positive or negative charge) on the surface of sample 304. The extra charge may build up locally on or near the surface of sample 304, which may be referred to as a SEM-induced charging effect.

Typically, insulating materials (e.g., many types of resists) may be positively charged, because the outgoing electrons (e.g., BSEs or SEs) typically exceeds the incoming electrons of the primary electron beam of a SEM, and extra positive charge builds up on or near the surface of the insulator material. Fig. 3 shows a case where the SEM-induced charging effect occurs and causes positive charge accumulated on the surface of insulator sample 304. The positive charge may be physically modelled as holes 312. In Fig. 3, the electrons of primary electron beam 302 injected into interaction volume 306 may diffuse to the neighbouring volume of interaction volume 306, which may be referred to as diffused electrons, such as diffused charge 314. The diffused electrons may recombine with positive charge (e.g., holes) in sample 304, such as recombination pair 316. The diffusion and recombination of charge may affect the distribution of holes 312. Holes 312 may cause a problem by, e.g., attracting BSEs and SEs back to the surface of sample 304, increasing the landing energy of the electrons of primary electron beam 302, causing the electrons of primary electron beam 302 to deviate from their intended landing spot, or interfering with an electric field between the surface of insulator sample 304 and an electron detector of BSEs and SEs, such as electron detector 206 in Fig. 2 .

The SEM-induced charging effect may attenuate and distort the SEM signals received by the electron detector, which may further distort acquired SEM images. Also, because sample 304 is non-conductive, as primary electron beam 302 scans across its surface, positive charge may be accumulated along the path of primary electron beam 302. Such accumulation of positive charge may increase or complicate the distortion in the acquired SEM images. Such distortion caused by the SEM-induced charging effect may be referred to as SEM-induced charging artifacts. Because the charge accumulates mainly along the path of the primary electron beam 302, SEM-induced charging artifacts may primarily arise along the scan direction. The SEM-induced charging artifacts may induce error in estimating geometrical size of fabricated structures or cause misidentification of defects in an inspection.

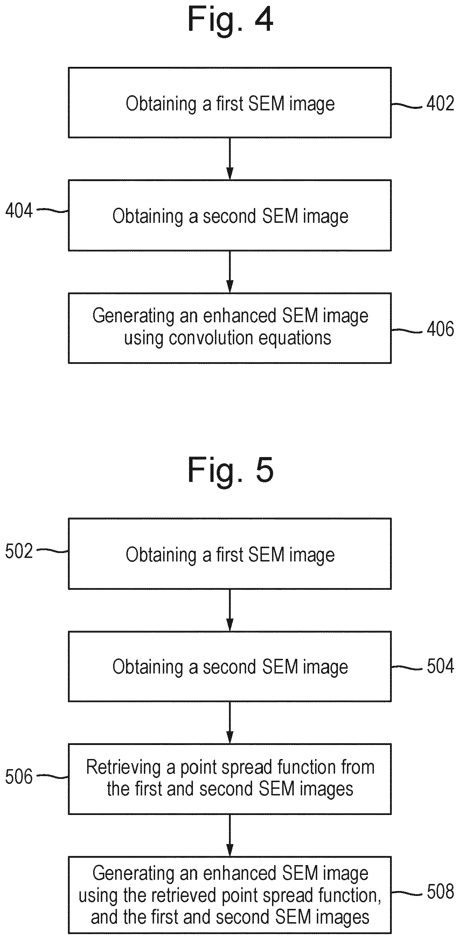

Reference is now made to Fig. 4, a flowchart which illustrates a method of generating SEM images according to an embodiment of the present disclosure. The method uses a diversity technique, such as a phase-diversity technique or a direction diversity technique, to infer SEM-induced charging artifacts from the image data. The method uses two or more acquired SEM images. One of the SEM images is a SEM image acquired using techniques described above that may be suffering from unknown SEM-induced charging artifacts. One or more additional SEM images are then acquired while changing the unknown SEM-induced charging artifacts in a known manner. For example, a parameter of the SEM electron beam scan may be altered. An enhanced SEM image may then be generated with reduced SEM-induced charging artifacts.

The method according to embodiments may be particularly advantageous close to feature edges of an imaging object. The method according to embodiments may be particularly advantageous close to feature edges parallel to a scan direction.

At step 402, a first SEM electron beam scan is performed of one or more features of an imaging object (e.g. a wafer or sample). A first SEM image may thus be obtained.

The first SEM electron beam scan is performed using a set of parameters with a first set of values. The set of parameters includes beam properties and scan properties. The beam properties may include, for example, beam current and beam profile of the electron beam. The scan properties may include, for example, scan direction and scan velocity, of the electron beam scan.

At step 404, a second SEM electron beam scan is performed of one or more features of an imaging object. A second SEM image may thus be obtained.

The second SEM electron beam scan is performed using a set of parameters with a second set of values. The second set of predetermined values differs from the first set of values for one of the parameters in the set of parameters. That is, one of the SEM electron beam scan properties is altered. In an embodiment, the second electron beam scan is performed with a beam property that differs from the corresponding beam property of the first electron beam scan. In another embodiment, the second electron beam scan is performed with a scan property that differs from the corresponding scan property of the first electron beam scan. In an embodiment, the two scans are performed with different scan directions. In an embodiment the two scans are performed with different scan velocities. In an embodiment the two scans are performed with different beam currents. In an embodiment the two scans are performed with different beam profiles.

In an embodiment, the same electron beam may be used in obtaining both the first SEM image and the second SEM image. In an alternative embodiment, the electron beam used in obtaining the first SEM image may be identical to the electron beam used in obtaining the second SEM image. In yet another embodiment, the electron beam used in obtaining the first SEM image may be sufficiently similar to that obtaining the second SEM image. Sufficiently similar electron beams may, for example, be used where the differences in electron beam characteristics, apart from any difference introduced by an altered beam property, do not substantially influence the images obtained. For example, a multi-beam SEM may be used in obtaining the SEM images. One of the electron beams in the multi-beam may then be used to obtain the first SEM image, while a different electron beam in the multi-beam may be used to obtain the second SEM image.

In an embodiment, the same feature may be scanned by the first and second scans. In an alternative embodiment, one set of features may be scanned in the first scan, and a corresponding second set of features may be scanned in the second scan, provided that the first set of features is sufficiently similar to the second set of features. For example, a first row of holes may be scanned in a first direction, and a second row of holes may be scanned in a second direction. Provided that the holes are sufficiently similar (as may be the case in a high-precision manufacturing apparatus as a lithographic apparatus) an enhanced SEM image according to embodiments may be obtained. In such an arrangement, the throughput may be increased because each row of holes are only scanned once.

The present disclosure is not limited to the imaging of any specific type of feature. Although previous examples have been directed to imaging of contact holes, this is merely one of many possible features for which the method may be used. Other possible features include, but are not restricted to, lines and spaces, pillars, tip to tip features, and tip to line to tip features.

At step 406, an enhanced SEM image is generated from the first and second obtained SEM images. The generated SEM image may have a reduced effect from SEM-induced charging artifacts.

The generation of the enhanced SEM image from the first and second SEM images will now be described.

The first SEM image may be described by the equation:

$$I_A(x) = (I_{true} * PSF_A)(x) \tag{1}$$

where $I_A(x)$ denotes the obtained first SEM image as a function of position $x$, $I_{true}$ denotes the true ground image (which is sought), $PSF_A$ denotes a point spread function of the first SEM image (referred to as the first point spread function), and * denotes the convolution operator defined as:

$$(f * g)(t) := \int_{-\infty}^{\infty} f(\tau)g(t - \tau)d\tau \tag{2}$$

It is appreciated that t is merely a variable of functions $f$ and $g$, and does not necessarily denote time.

The point spread function may be described as the impact of SEM-induced charging artifacts on the SEM image. In the absence of SEM-induced charging artifacts, the point spread function may be described by the Dirac delta function. The point spread function may also more generally be described as the impulse response of the imaging system. The point spread function is thus related to the 'blurring' of the imaging system.

The second SEM image may similarly be described by the equation:

$$I_B(x) = (I_{true} * PSF_B)(x) \tag{3}$$

where $I_B(x)$ denotes the obtained second SEM image and $PSF_B$ denotes the point spread function of the second SEM image (referred to as the second point spread function).

Accordingly, a system comprising two equations (equations 1 and 3) and three unknowns ($I_{true}$, $PSF_A$ and $PSF_B$) may describe the relation between the true ground image and the obtained first and second SEM images.

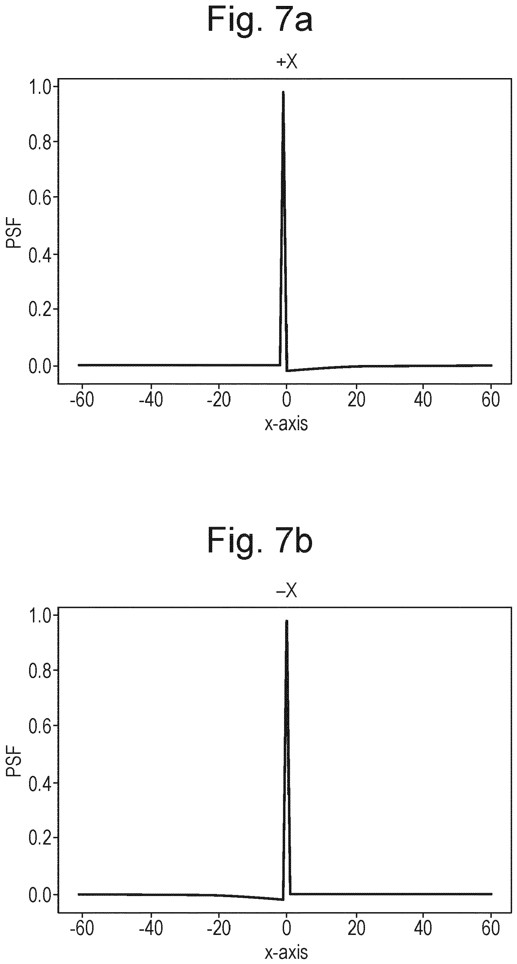

Furthermore, the point spread function of the first image, $PSF_A$, may be related to the point spread function of the second image, $PSF_B$. The two point spread functions may be related based on the (known) alteration in an electron beam scan parameter value between the first and second electron beam scans. This will be discussed in more detail in relation to Fig. 7.

Accordingly, a system of equations is obtained comprising two equations and two unknowns. By solving the two equations simultaneously, the enhanced SEM image may be generated.

The system of equations may be solved by any suitable known method. Solving methods may include analytical solving methods and numerical solving methods. In some embodiments, the two equations are solved computationally.

Reference is now made to Fig. 5, a flowchart which illustrates a method of generating SEM images according to an embodiment of the present disclosure. The flowchart illustrates, in particular, a preferred embodiment where the system of equations discussed above is solved in two steps by first retrieving the point spread function, and then generating the enhanced SEM image.

At step 502, a first SEM image is obtained, for example, as described in relation to step 402 of Fig. 4.

At step 504, a second SEM image is obtained, for example, as described in relation to step 404 of Fig. 4.

At step 506, one of the first and second point spread functions is retrieved. The point spread function that is retrieved of the first and second point spread functions, is retrieved by solving the two simultaneous equations 1 and 2 outlined above. Once one of the first and second point spread functions has been retrieved, the other of the first and second point spread functions may be obtained by the relationship between the first and second point spread functions.

The point spread function may be retrieved by solving the two simultaneous equations pixel by pixel.

The point spread function may alternatively be retrieved by parametrising the point spread function using a parametrisation model. This may significantly reduce the computational complexity, computational cost and/or computational time. In an embodiment the point spread function may be described by a parametrisation model given by:

$$PSF(x) = \varepsilon \delta(x) - a e^{-\gamma x} \sin(bx + c)\, \theta(x) \qquad (4)$$

where $\varepsilon$, $\alpha$, $\gamma$, $b$ and $c$ are optimisation or fitting parameters to be determined, $\delta(x)$ is the Dirac/Kroneker delta function, and $\theta(x)$ is the Heaviside step function.

In another embodiment the point spread function may alternatively be described by a 2D parametrisation model given by:

$$PSF(x, y) = (\varepsilon \delta(x) - a e^{-\gamma x} \sin(bx + c)\, \theta(x)) e^{-Dy^2} \qquad (5)$$

where D is an optimization or fitting parameter to be determined.

The present disclosure is not limited to the above examples of parametrisation models, and any suitable parametrisation model may be used in retrieving the point spread function.

The two equations 1 and 3 can be solved simultaneously for the two unknowns. The equations may be solved by an optimization approach where a cost function may be formulated as a squared difference between the obtained SEM images and the true ground SEM image. The squared difference may be formulated as:

$$L = \sum_x [I_A(x) - (I_{true} * PSF_A)(x)]^2 + [I_B(x) - (I_{true} * PSF_B)(x)]^2 \qquad (6)$$

The cost function may then be used by any suitable optimization approach, for example an optimization approach which iteratively finds the *PSF* and $I_{true}$ that leads to a local or global minimum of the scalar cost factor *L*. In embodiments, the cost function may be first solved for the point spread function by eliminating the unknown $I_{true}$.

As another example, the scalar cost factor L may be an absolute difference instead of a squared difference.

In embodiments where measurement noise reduces the likelihood of retrieving accurate values of the point spread function and true ground image, the formulation of the cost function may be extended to include a so-called regularization term or prior term. The process of solving the simultaneous equations may then be more robust to noise issues.

At step 508, the enhanced SEM image is generated using the retrieved point spread function. The generated SEM image may have a reduced effect from SEM-induced charging artifacts.

The enhanced SEM image may be generated from the system of equations, using the first and second SEM images, together with the retrieved point spread function.

The enhanced SEM image may be generated from the system of simultaneous equations by any suitable known method.

In an embodiment, the enhanced SEM image is generated through the use of Fourier transforms. The Fourier transforms may be, but are not limited to, fast Fourier transforms.

In an embodiment, after having retrieved the point spread function, the enhanced SEM image may be generated by the equation:

$$I_{enhanced} = \mathrm{FFT}^{-1} \left\{ \frac{\mathrm{FFT}(I_A)\mathrm{FFT}(PSF_A)^* + \mathrm{FFT}(I_B)\mathrm{FFT}(PSF_B)^*}{|\mathrm{FFT}(PSF_A)|^2 + |\mathrm{FFT}(PSF_B)|^2} \right\} \qquad (7)$$

where $I_{enhanced}$ denotes the generated enhanced SEM image, FFT denotes the fast Fourier transform, FFT$^{-1}$ denotes

its inverse, the superscript * denotes the complex conjugate, and |x| denotes the modulus or absolute value of *x*.

In embodiments, the true ground image may alternatively be generated by again using an optimization approach. For example, the true ground image may be generated by using the cost function in equation 6. Since the point spread function may already have been retrieved, the only unknown in the cost function would be the true ground image. Similarly to when retrieving the point spread function, the cost function may be defined as any suitable cost function, for example, as a squared difference, such as that in equation 6, or as an absolute difference. A regularization term or prior term may be introduced to improve the accuracy or stability when noise is present.

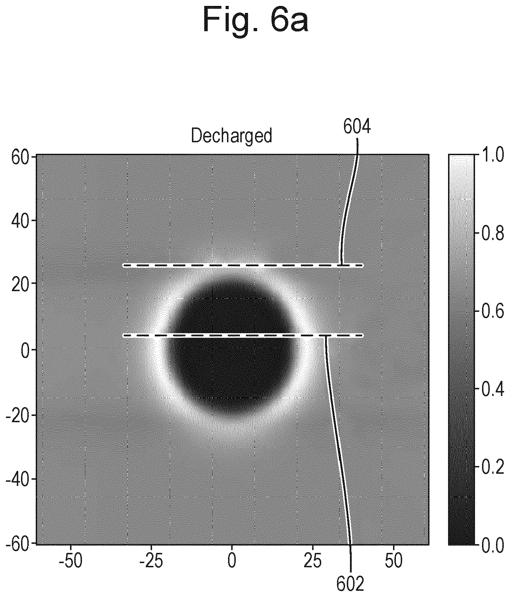

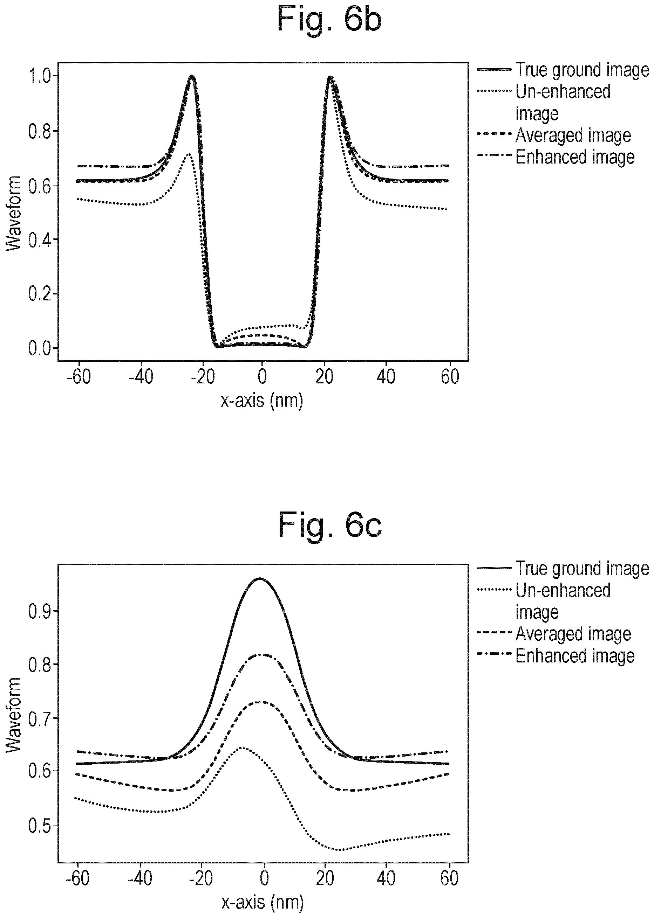

Reference will now be made to Fig. 6, which illustrates an exemplary enhanced SEM image according to embodiments. Fig. 6(a) shows a simulated SEM image of a contact hole. The simulated SEM image has first scan line 602, and a second scan line 604. The first scan line 602 crosses one or more edges of the feature. The second scan line 604 is located close to, and parallel to, a feature edge.

Fig. 6(b), illustrates a waveform of the SEM image at the first scan line 602. Fig. 6(b) shows the waveform of an enhanced SEM image generated using a first simulated SEM image and a second simulated SEM image obtained through simulations with opposite scan directions along the first scan line 602. Fig. 6(b) further compares the enhanced SEM image generated according to embodiments with the simulated true ground SEM image, a simulated SEM image without the use of any enhancement techniques, and a SEM image generated by averaging the first simulated SEM image and the second simulated SEM image.

It may be seen that embodiments provide an enhanced SEM image that is significantly closer to the ground truth image, at least in certain regions, compared to non-enhanced SEM images.

Fig. 6(c), illustrates a waveform of the SEM image at the second scan line 604. Fig. 6(c) shows the waveform of an enhanced SEM image generated using a first simulated SEM image and a second simulated SEM image obtained through simulations with opposite scan directions along the second scan line 604. Fig. 6(c) further compares the enhanced SEM image generated according to embodiments with the simulated true ground SEM image, a simulated SEM image without the use of any enhancement techniques, and a SEM image generated by averaging the first simulated SEM image and the second simulated SEM image.

It may be seen that embodiments are particularly advantageous when the SEM electron scan beam moves parallel to a feature edge. As described in the background section, a known technique of reducing SEM-induced charging artifacts is to acquire several SEM images using different scan directions, and averaging these. Embodiments provide a significant improvement over averaging techniques, in particular as the SEM electron beam scan moves along a feature edge. This is because the SEM signal is known to diminish when the scan beam moves parallel along the feature edge. Thus, when obtaining two SEM images using opposing scan directions, averaging of the two SEM images cannot provide an improved image since the artifact is equally present in both forward and backward scan directions.

Accordingly, enhanced SEM images generated according to embodiments may have a reduced effect from SEM-induced charging artifacts compared to other known techniques of enhancing SEM images. Embodiments may further provide a significant improvement over non-enhanced SEM images. Enhanced SEM images generated according to embodiments may be identical to the ground truth images.

Embodiments provide a further advantage over prior known techniques. When the SEM electron scan beam moves parallel to a feature edge, the diminished SEM signal may lead to problems in contouring of the features in the SEM images. Accordingly, missing contours' may be present. Embodiments provide enhanced SEM images with feature edges with improved clarity, and thus prevents missing contours'.

Reference will now be made to an example embodiment where the first and second scans are performed with opposite scan directions.

The equations describing the first and second SEM images may then be described by:

$$I_{x,-x}(x) = \left( I_{true} * PSF_{x,-x} \right)(x) \tag{6}$$

where subscript *x* is used to denote a scan in a positive x-direction, and subscript *-x* is used to denote a scan in a negative x-direction.

The first and second point spread functions may be related based on a known difference in SEM-induced charging artifacts due to the two opposite scan directions. As discussed previously, SEM-induced charging artifacts are primarily present along the scan direction of the SEM electron beam scan. Accordingly, if the scan direction is altered, the primary axis of the SEM-induced charging artifacts is altered in a similar manner. Furthermore, the point spread function is related to the SEM-induced charging artifacts. Accordingly, the point spread function is related to the scan direction. In an example where the second scan direction is opposite to the first scan direction, the second scan direction is a reflection of the first scan direction in a plane orthogonal to the first scan direction. Accordingly, in a similar manner, the second point spread function is a reflection of the first point spread function in a plane orthogonal to an axis representing a direction parallel to the first scan direction. In other words, the second point spread function is a mirrored version of the first point spread function.

This may be seen in Fig. 7, which illustrates how the first and second point spread functions are related for this example with opposite scan directions. Fig. 7(a) shows the first point spread function. Fig. 7(b) shows the second point spread function.

By using this relation between the first and second point spread functions in the system of simultaneous equations, the enhanced SEM image may be generated by any of the above-discussed methods of solving the simultaneous equations.

Reference will now be made to example embodiments where the first and second scans are performed with different scan directions, but not necessarily opposite scan directions.

The first and second scan directions may be suitable scan directions depending on the geometry of the feature of interest.

The first and second point spread functions may then be related to each other in a similar, but more general, manner to the previous example with opposite scan directions.

Again, the first and second point spread functions may be related based on a known difference in SEM-induced charging artifacts due to the two opposite scan directions. As discussed previously, SEM-induced charging artifacts are primarily present along the scan direction of the SEM electron beam scan, and the point spread function is related to the SEM-induced charging artifacts. Accordingly, the point spread function is related to the scan direction.

The first and second scan directions may be considered as vectors indicating their directions. In an example where the second scan direction is different from the first scan direction, the second scan direction vector may be considered to be a rotation of the first scan direction vector, by a rotation amount, in a plane comprising the first and second scan direction vectors (or in other words, a rotation about an axis orthogonal to both the first and second scan direction vectors). Accordingly, in a similar manner, the second point spread function is a rotation of the first point spread function, by the rotation amount, about an axis representing a direction orthogonal to the first and second scan directions.

For example, in a 3D geometry described by orthogonal x-y-z axes, where the first and second scan direction vectors are in an x-y plane, the second scan direction vector is a rotation of the first scan direction vector, by a rotation amount, about a z-axis. Similarly, the second point spread function would then be a rotation of the first point spread function, by the rotation amount, about the z-axis.

By using this relation between the first and second point spread functions in the system of simultaneous equations, the enhanced SEM image may be generated by any of the above-discussed methods of solving the simultaneous equations.

Reference will now be made to example embodiments where a different electron beam scan parameter than scan direction is altered between the first scan and the second scan. The altered electron beam scan parameter may include scan velocity, beam current or beam profile.

In an example where the scan velocity is altered between the two SEM images, the first and second point spread functions may be related based on a known difference in SEM-induced charging artifacts due to the two different scan velocities. An alteration of the scan velocity will yield a dilated or contracted version of the point spread function. In other words, the point spread function has been scaled by a known scan velocity change induced amount.

In an example where the beam profile is altered between the two SEM images, the beam profile may be altered, for example, by changing the strength of a lens such that the beam may become defocused. The first and second point spread functions may then be related based on a known difference in SEM-induced charging artifacts due to the defocus (or other change in the beam profile). An alteration of focus of a beam will result in an isotropic dilation of the point spread function. This is similar to phase-diversity techniques used in optics.

In an example where the beam current is altered between the two SEM images, the lower beam current may be sufficiently small to not incur significant SEM-induced charging artifacts. The higher beam current may then be sufficiently large to be substantially impacted by SEM-induced charging artifacts. Equations 1 and 3 may then be described by:

$$I_A(x) = I_{true}(x) + n_A(x) \tag{8}$$

$$I_B(x) = (I_{true} * PSF_B)(x) + n_B(x) \tag{9}$$

where $n_A(x)$ and $n_B(x)$ is noise in the respective SEM images. The contribution of noise $n_B(x)$ in equation 9 (i.e. the measurement with higher beam current) may be negligible compared to the contribution of noise $n_A(x)$ in equation 8 (i.e. the measurement with lower beam current).

Hence, there are two equations with two unknowns for which a solution will be sought ($I_{true}$ and $PSF_B$). The additional noise terms $n_A(x)$ and $n_B(x)$ may be automatically dealt with in the optimization approach by either using a suitable parametrization model for the point spread function, for example a parametrization model that does not overfit a solution with noise, or by including additional regularization terms or prior terms in the optimization approach. Both of these modifications to the optimization approach have been described previously.

Enhanced SEM images may be generated according to embodiments even if noise is present in the first and second SEM images.

In processing SEM images with noise, noise-reduction techniques may be used. In processing SEM images with noise, the method of solving the system of simultaneous equations according to embodiments may be modified to include appropriate regularization choices. For example, the method of solving the system of simultaneous equations according to embodiments may be modified to include in the optimization cost function a squared norm $|I_{true}|^2$ of the unknown true ground image, a total variation $|\nabla I_{true}|$ of the unknown true ground image, or any other suitable technique known from the fields of image processing or optimization, such as non-local means and elastic net.

Embodiments include the use of additional SEM images, in addition to the first and second SEM images. The enhanced SEM image may thus be improved further. The enhanced SEM image may have an even further reduced effect from SEM-induced charging artifacts. The additional SEM images may be obtained through scans with further altered electron beam scan parameters. For example, one or more additional SEM image obtained using one or more additional scan direction may be used. In an embodiment, each additional SEM image has an alteration distinct from every other SEM image.

Relative dimensions of components in drawings may be exaggerated for clarity. Within the following description of drawings, the same or like reference numbers refer to the same or like components or entities, and only the differences with respect to the individual embodiments are described.

As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

A non-transitory computer readable medium may be provided that stores instructions for a processor of a controller to carry out image inspection, image acquisition, activating charged-particle source, adjusting electrical excitation of stigmators, adjusting landing energy of electrons, adjusting objective lens excitation, adjusting secondary electron detector position and orientation, stage motion control, beam separator excitation, applying scan deflection voltages to beam deflectors, receiving and processing data associated with signal information from electron detectors, configuring an electrostatic element, detecting signal electrons, adjusting the control electrode potential, adjusting the voltages applied to the electron source, extractor electrode, and the sample, etc. Common forms of non-transitory media include, for example, a floppy disk, a flexible disk, hard disk, solid state drive, magnetic tape, or any other magnetic data storage medium, a Compact Disc Read Only Memory (CD-ROM), any other optical data storage medium, any physical medium with patterns of holes, a Random Access Memory (RAM), a Programmable Read Only Memory (PROM), and Erasable Programmable Read Only Memory (EPROM), a FLASH-EPROM or any other flash memory, Non-Volatile Random Access Memory (NVRAM), a cache, a register, any other memory chip or cartridge, and networked versions of the same.

The embodiments may further be described using the following clauses:

1. A method of reducing a sample charging effect in a scanning electron microscope (SEM) image, the method comprising:

    obtaining a first SEM image from a first electron beam scan with a parameter being a first quantity;
    obtaining a second SEM image from a second electron beam scan with the parameter being a second quantity different from the first quantity; and
    generating a reduced sample charging effect image based on convolution equations comprising a representation of the first SEM image, a representation of the second SEM image, a first point spread function corresponding to the first SEM image and a second point spread function corresponding to the second SEM image.

2. The method according to clause 1, wherein the step of generating the reduced sample charging effect image comprises relating the first point spread function to the second point spread function in dependence on a difference in sample charging effect between the first electron beam scan and the second electron beam scan.

3. The method according to clause 1 or 2, wherein the step of generating the reduced sample charging effect image comprises retrieving one or both of the first and second point spread functions from the first and second SEM images using the convolution equations.

4. The method according to clause 3, wherein the step of retrieving one or both of the first and second point spread functions comprises expressing the point spread function in a parameterized form.

5. The method according to clause 3 or 4, wherein the step of generating the reduced sample charging effect image comprises using the retrieved point spread functions to generate the reduced sample charging effect image.

6. The method according to any preceding clause, wherein the parameter is a scan direction.

7. The method according to clause 6, wherein the first quantity is a first direction, and wherein the second quantity is a second direction opposite to the first direction.

8. The method according to clause 7, wherein the second point spread function is a reflection of the first point spread function about a plane orthogonal to an axis representing a direction parallel to the first direction.

9. The method according any of clauses 1 to 5, wherein the parameter is a scan velocity.

10. The method according to any of clauses 1 to 5, wherein the parameter is an electron beam current.

11. The method according to any preceding clause, wherein the reduced sample charging effect image is generated in dependence on one or more equations comprising one or more Fourier transform operations.

12. The method according to any preceding clause, wherein the method further comprises obtaining one or more additional SEM images from additional electron beam scans with the parameter for each of the additional electron beam scans being quantities different from the first and second quantities.

13. The method according to any preceding clause, wherein the method further comprises:

> performing the first electron beam scan using a scanning electron microscope; and
> performing the second electron beam scan using the scanning electron microscope.

14. A computer program product comprising a non-transitory computer readable medium having instructions recorded thereon, the instructions when executed by a computer implementing the method of any of the above clauses.

15. A system comprising:

> a scanning electron microscope (SEM) configured to scan with an electron beam and generate an image; and
> a non-transitory machine-readable medium storing instructions which, when executed by a processor, cause the processor in co-operation with the SEM to perform operations comprising:

>> obtaining a first SEM image from a first electron beam scan with a parameter being a first quantity;
>> obtaining a second SEM image from a second electron beam scan with the parameter being a second quantity different from the first quantity; and
>> generating a reduced sample charging effect image based on convolution equations comprising a representation of the first SEM image, a representation of the second SEM image, a first point spread function corresponding to the first SEM
>> image and a second point spread function corresponding to the second SEM image

16. A method of reducing a sample charging effect in a scanning electron microscope (SEM) image, the method comprising:

> obtaining a first SEM image from an electron beam scan with a parameter being a first quantity;
> obtaining a second SEM image from an electron beam scan with the parameter being a second quantity different from the first quantity; and
> generating a reduced sample charging effect image based on a first and a second convolution equation; wherein:

>> the first convolution equation comprises:

>>> a representation of the first scanning electron microscope image; and
>>> a first charging point spread function corresponding to the first scanning electron microscope image; and

>> the second convolution equation comprises:

>>> a representation of the second scanning electron microscope image; and
>>> a second charging point spread function corresponding to the second scanning electron microscope image.

17. The method according to clause 16, wherein the step of generating the reduced sample charging effect image comprises relating the first point spread function to the second point spread function in dependence on a difference in sample charging effect between the first electron beam scan and the second electron beam scan.

18. The method according to clause 16 or 17, wherein the step of generating the reduced sample charging effect image comprises retrieving one or both of the first and second point spread functions from the first and second SEM images using the convolution equations.

19. The method according to clause 18, wherein the step of retrieving one or both of the first and second point spread functions comprises expressing the point spread function in a parameterized form.

20. The method according to clause 18 or 19, wherein the step of generating the reduced sample charging effect image comprises using the retrieved point spread functions to generate the reduced sample charging effect image.

21. The method according to any of clauses 16 to 20, wherein the parameter is a scan direction.

22. The method according to clause 21, wherein the first quantity is a first direction, and wherein the second quantity is a second direction opposite to the first direction.

23. The method according to clause 22, wherein the second point spread function is a reflection of the first point spread function about a plane orthogonal to an axis representing a direction parallel to the first direction.

24. The method according any of clauses 16 to 20, wherein the parameter is a scan velocity.

25. The method according to any of clauses 16 to 20, wherein the parameter is an electron beam current.

26. The method according to any of clauses 16 to 25, wherein the reduced sample charging effect image is generated in dependence on one or more equations comprising one or more Fourier transform operations.

27. The method according to any of clauses 16 to 26, wherein the method further comprises obtaining one or more additional SEM images from additional electron beam scans with the parameter for each of the additional electron beam scans being quantities different from the first and second quantities.

28. The method according to any of clauses 16 to 27, wherein the method further comprises:

performing the first electron beam scan using a scanning electron microscope; and
performing the second electron beam scan using the scanning electron microscope.

29. A computer program product comprising a non-transitory computer readable medium having instructions recorded thereon, the instructions when executed by a computer implementing the method of clause 16.

30. A system comprising:

a scanning electron microscope (SEM) configured to scan with an electron beam and generate an image; and
a non-transitory machine-readable medium storing instructions which, when executed by a processor, cause the processor in co-operation with the SEM to perform operations comprising:

obtaining a first SEM image from an electron beam scan with a parameter being a first quantity;
obtaining a second SEM image from an electron beam scan with the parameter being a second quantity different from the first quantity; and
generating a reduced sample charging effect image based on a first and a second convolution equation; wherein:

the first convolution equation comprises:

a representation of the first scanning electron microscope image; and
a first charging point spread function corresponding to the first scanning electron microscope image; and

the second convolution equation comprises:

a representation of the second scanning electron microscope image; and
a second charging point spread function corresponding to the second scanning electron microscope image.

31. A method of reducing a sample charging effect in a scanning electron microscope (SEM) image, the method comprising:

obtaining a first SEM image from a first electron beam scan with a parameter being a first quantity;
obtaining a second SEM image from a second electron beam scan with the parameter being a second quantity different from the first quantity;
retrieving a point spread function from the first and second SEM images using convolution equations;
generating a reduced sample charging effect image based on convolution equations comprising a representation of the first SEM image, a representation of the second SEM image, and the retrieved point spread function.

32. The method according to clause 31, wherein the step of retrieving the point spread function comprises relating a first point spread function to a second point spread function in dependence on a difference in sample charging effect between the first electron beam scan and the second electron beam scan.

33. The method according to clause 31 or 32, wherein the step of retrieving the point spread function comprises expressing the point spread function in a parameterized form.

34. The method according to any of clauses 31 to 33, wherein the parameter is a scan direction.

35. The method according to clause 34, wherein the first quantity is a first direction, and wherein the second quantity is a second direction opposite to the first direction.

36. The method according any of clauses 31 to 33 wherein the parameter is a scan velocity.

37. The method according to any of clauses 31 to 33, wherein the parameter is an electron beam current.

38. The method according to any of clauses 31 to 37, wherein the reduced sample charging effect image is generated in dependence on one or more equations comprising one or more Fourier transform operations.

39. The method according to any of clauses 31 to 38, wherein the method further comprises obtaining one or more additional SEM images from additional electron beam scans with the parameter for each of the additional electron beam scans being quantities different from the first and second quantities.

40. The method according to any of clauses 31 to 39, wherein the method further comprises:

performing the first electron beam scan using a scanning electron microscope; and
performing the second electron beam scan using the scanning electron microscope.

41. A computer program product comprising a non-transitory computer readable medium having instructions recorded thereon, the instructions when executed by a computer implementing the method of clause 31.

42. A system comprising:

a scanning electron microscope (SEM) configured to scan with an electron beam and generate an image; and
a non-transitory machine-readable medium storing instructions which, when executed by a processor, cause the processor in co-operation with the SEM to perform operations comprising:

obtaining a first SEM image from a first electron beam scan with a parameter being a first quantity;
obtaining a second SEM image from a second electron beam scan with the parameter being a second quantity different from the first quantity;
retrieving a point spread function from the first and second SEM images using convolution equations;
generating a reduced sample charging effect image based on convolution equations comprising a representation of the first SEM image, a representation of the second SEM image, and the retrieved point spread function.

43. A method comprising:

obtaining a first SEM image from a first electron beam scan with a parameter being a first quantity;
obtaining a second SEM image from a second electron beam scan with the parameter being a second quantity different from the first quantity; and
generating an image based on convolution equations comprising a representation of the first SEM image, a representation of the second SEM image, a first point spread function corresponding to the first SEM image and a second point spread function related to the first point spread function in dependence on a difference in sample charging effect between the first electron beam scan and the second electron beam scan.

44. The method according to clause 43, wherein the generated image is an image with a reduced sample charging effect.

45. The method according to clause 43 or 44, wherein the step of generating the reduced sample charging effect image comprises retrieving one or both of the first and second point spread functions from the first and second SEM images using the convolution equations.

46. The method according to clause 45, wherein the step of retrieving one or both of the first and second point spread functions comprises expressing the point spread function in a parameterized form.

47. The method according to clause 45 or 46, wherein the step of generating the reduced sample charging effect image comprises using the retrieved point spread functions to generate the reduced sample charging effect image.

48. The method according to any of clauses 43 to 47, wherein the parameter is a scan direction.

49. The method according to clause 48, wherein the first quantity is a first direction, and wherein the second quantity is a second direction opposite to the first direction.

50. The method according to clause 49, wherein the second point spread function is a reflection of the first point spread function about a plane orthogonal to an axis representing a direction parallel to the first direction.
51. The method according any of clauses 43 to 47, wherein the parameter is a scan velocity.
52. The method according to any of clauses 43 to 47, wherein the parameter is an electron beam current.
53. The method according to any of clauses 43 to 52, wherein the reduced sample charging effect image is generated in dependence on one or more equations comprising one or more Fourier transform operations.
54. The method according to any of clauses 43 to 53, wherein the method further comprises obtaining one or more additional SEM images from additional electron beam scans with the parameter for each of the additional electron beam scans being quantities different from the first and second quantities.
55. The method according to any of clauses 43 to 53, wherein the method further comprises:

> performing the first electron beam scan using a scanning electron microscope; and
> performing the second electron beam scan using the scanning electron microscope.

56. A computer program product comprising a non-transitory computer readable medium having instructions recorded thereon, the instructions when executed by a computer implementing the method of clause 43.
57. A system comprising:

> a scanning electron microscope (SEM) configured to scan with an electron beam and generate an image; and
> a non-transitory machine-readable medium storing instructions which, when executed by a processor, cause the processor in co-operation with the SEM to perform operations comprising:
>
>> obtaining a first SEM image from a first electron beam scan with a parameter being a first quantity;
>> obtaining a second SEM image from a second electron beam scan with the parameter being a second quantity different from the first quantity; and
>> generating an image based on convolution equations comprising a representation of the first SEM image, a representation of the second SEM image, a first point spread function corresponding to the first SEM image and a second point spread function related to the first point spread function in dependence on a difference in sample charging effect between the first electron beam scan and the second electron beam scan.

It will be appreciated that the embodiments of the present disclosure are not limited to the exact construction that has been described above and illustrated in the accompanying drawings, and that various modifications and changes may be made without departing from the scope thereof. The present disclosure has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.
The descriptions above are intended to be illustrative, not limiting. Thus, it will be apparent to one skilled in the art that modifications may be made as described without departing from the scope of the claims set out below.

**Claims**

1. A computer program product comprising a non-transitory computer readable medium having instructions recorded thereon, the instructions when executed by a computer implementing a method comprising:

> obtaining a first SEM image from a first electron beam scan with a parameter being a first quantity;
> obtaining a second SEM image from a second electron beam scan with the parameter being a second quantity different from the first quantity; and
> generating a reduced sample charging effect image based on convolution equations comprising a representation of the first SEM image, a representation of the second SEM image, a first point spread function corresponding to the first SEM image and a second point spread function corresponding to the second SEM image.

2. The computer program product according to claim 1, wherein the step of generating the reduced sample charging effect image comprises relating the first point spread function to the second point spread function in dependence on a difference in sample charging effect between the first electron beam scan and the second electron beam scan.

3. The computer program product according to claim 1, wherein the step of generating the reduced sample charging effect image comprises retrieving one or both of the first and second point spread functions from the first and second SEM images using the convolution equations.

4. The computer program product according to claim 3, wherein the step of retrieving one or both of the first and second point spread functions comprises expressing the point spread function in a parameterized form.

5. The computer program product according to claim 3, wherein the step of generating the reduced sample charging effect image comprises using the retrieved point spread functions to generate the reduced sample charging effect image.

6. The computer program product according to claim 1, wherein the parameter is a scan direction.

7. The computer program product according to claim 6, wherein the first quantity is a first direction, and wherein the second quantity is a second direction opposite to the first direction.

8. The computer program product according to claim 7, wherein the second point spread function is a reflection of the first point spread function about a plane orthogonal to an axis representing a direction parallel to the first direction.

9. The computer program product claim 1, wherein the parameter is a scan velocity.

10. The computer program product according to claim 1, wherein the parameter is an electron beam current.

11. The computer program product according to claim 1, wherein the reduced sample charging effect image is generated in dependence on one or more equations comprising one or more Fourier transform operations.

12. The computer program product according to claim 1, wherein the method further comprises obtaining one or more additional SEM images from additional electron beam scans with the parameter for each of the additional electron beam scans being quantities different from the first and second quantities.

13. The computer program product according to claim1, wherein the method further comprises:

performing the first electron beam scan using a scanning electron microscope; and
performing the second electron beam scan using the scanning electron microscope.

14. A system comprising:

a scanning electron microscope (SEM) configured to scan with an electron beam and generate an image; and
a non-transitory machine-readable medium storing instructions which, when executed by a processor, cause the processor in co-operation with the SEM to perform operations comprising:

obtaining a first SEM image from a first electron beam scan with a parameter being a first quantity;
obtaining a second SEM image from a second electron beam scan with the parameter being a second quantity different from the first quantity; and
generating a reduced sample charging effect image based on convolution equations comprising a representation of the first SEM image, a representation of the second SEM image, a first point spread function corresponding to the first SEM image and a second point spread function corresponding to the second SEM image.

15. A method of reducing a sample charging effect in a scanning electron microscope (SEM) image, the method comprising:

obtaining a first SEM image from a first electron beam scan with a parameter being a first quantity;
obtaining a second SEM image from a second electron beam scan with the parameter being a second quantity different from the first quantity; and
generating a reduced sample charging effect image based on convolution equations comprising a representation of the first SEM image, a representation of the second SEM image, a first point spread function corresponding to the first SEM image and a second point spread function corresponding to the second SEM image.

# Fig. 1

Fig. 2

# Fig. 3

# Fig. 4

| Obtaining a first SEM image | 402 |

↓

| 404 | Obtaining a second SEM image |

↓

| Generating an enhanced SEM image using convolution equations | 406 |

# Fig. 5

| 502 | Obtaining a first SEM image |

↓

| Obtaining a second SEM image | 504 |

↓

| 506 | Retrieving a point spread function from the first and second SEM images |

↓

| Generating an enhanced SEM image using the retrieved point spread function, and the first and second SEM images | 508 |

# Fig. 6a

## Fig. 6b

## Fig. 6c

# Fig. 7a

+X

# Fig. 7b

−X

Europäisches
Patentamt

European
Patent Office

Office européen
des brevets

# EUROPEAN SEARCH REPORT

Application Number

EP 21 16 3831

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | US 2011/187847 A1 (BAI JIE [JP] ET AL) 4 August 2011 (2011-08-04)<br>* figs. 1, 2, 4-8, 13-20, 22-24 and related text *<br>* paragraphs [0081], [0085], [0090], [0108], [0113], [0118] *<br>----- | 1,2,6, 10-15<br>3-5 | INV.<br>G06T5/00<br>G06T5/10<br>G06T5/50<br>H01J37/22<br>H01J37/28 |
| X | US 2014/092231 A1 (NAKAHIRA KENJI [JP] ET AL) 3 April 2014 (2014-04-03)<br><br>* figs. 1, 2, 11, 12, 14, 17, 19, 20 and related text *<br>* paragraphs [0008], [0016], [0050], [0096] - [0101], [0140] - [0143] *<br>----- | 1,2, 6-11, 13-15 | |
| Y | US 2008/251719 A1 (NAKAHIRA KENJI [JP] ET AL) 16 October 2008 (2008-10-16)<br>* figs. 1, 4, 14, 16 and related text *<br>* paragraph [0015] *<br>----- | 3-5 | |

TECHNICAL FIELDS
SEARCHED      (IPC)

G06T
H01J

The present search report has been drawn up for all claims

| Place of search | Date of completion of the search | Examiner |
|---|---|---|
| Munich | 17 September 2021 | Krauss, Jan |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 21 16 3831

This annex lists the patent family members relating to the patent documents cited in the above-mentioned European search report.
The members are as contained in the European Patent Office EDP file on
The European Patent Office is in no way liable for these particulars which are merely given for the purpose of information.

17-09-2021

| Patent document cited in search report | | Publication date | Patent family member(s) | | Publication date |
|---|---|---|---|---|---|
| US 2011187847 | A1 | 04-08-2011 | JP | 5164754 B2 | 21-03-2013 |
| | | | JP | 2010062106 A | 18-03-2010 |
| | | | US | 2011187847 A1 | 04-08-2011 |
| | | | WO | 2010026833 A1 | 11-03-2010 |
| US 2014092231 | A1 | 03-04-2014 | JP | 5537488 B2 | 02-07-2014 |
| | | | JP | 2012226842 A | 15-11-2012 |
| | | | KR | 20130135345 A | 10-12-2013 |
| | | | US | 2014092231 A1 | 03-04-2014 |
| | | | WO | 2012140874 A1 | 18-10-2012 |
| US 2008251719 | A1 | 16-10-2008 | JP | 2008177064 A | 31-07-2008 |
| | | | US | 2008251719 A1 | 16-10-2008 |
| | | | US | 2012126117 A1 | 24-05-2012 |

EPO FORM P0459

For more details about this annex : see Official Journal of the European Patent Office, No. 12/82